(19) Europäisches Patentamt

European Patent Office

Office européen des brevets

(11) **EP 1 237 006 A2**

(12) **EUROPÄISCHE PATENTANMELDUNG**

(43) Veröffentlichungstag:
04.09.2002 Patentblatt 2002/36

(51) Int Cl.$^7$: **G01R 19/00**

(21) Anmeldenummer: 01130955.6

(22) Anmeldetag: 28.12.2001

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **01.03.2001 DE 10109833**

(71) Anmelder: **Power-One AG**
**8610 Uster (CH)**

(72) Erfinder: **Chapuis, Alain**
**8610 Uster (CH)**

(74) Vertreter: **Behrmann, Niels, Dipl.-Ing.**
**Hiebsch Behrmann**
**Patentanwälte**
**Heinrich-Weber-Platz 1**
**78224 Singen (DE)**

(54) **Vorrichtung zur leistungsarmen Stromerfassung**

(57) Die Erfindung betrifft eine Vorrichtung zur leistungsarmen Stromerfassung mittels eines eine Shuntspannung erzeugenden Shuntwiderstands ($R_{shunt}$), mit einem zum Verstärken der Shuntspannung in eine Messspannung ausgebildeten Verstärkernetzwerk, das eine erste, als Verstärker beschaltete Nullator-Norator-Kombination ($N_1$, /$N_1$) aufweist, wobei der ersten Nullator-Norator-Kombination eine zweite Nullator-Norator-Kombination ($B_2$) in Richtung auf den Shuntwiderstand so in Reihe vorgeschaltet ist, dass der erste Nullator und der zweite Nullator in einer Rückkopplung betrieben werden und eine Nichtlinearität des ersten Nullators durch ein entgegengesetztes Verhalten des zweiten Nullators kompensiert werden kann, wobei ein Rückkoppelsignal für die zweite Nullator-Norator-Kombination am Ausgang der ersten Nullator-Norator-Kombination abgegriffen wird.

Fig. 1

$$R_2 = x \cdot R$$

$$R_3 = K \cdot x \cdot R \quad (K > 1)$$

$B_1$ = Betriebsstromerzeugung für Linearisierer

$B_2$ = Linearisierelement

EP 1 237 006 A2

## Beschreibung

Die vorliegende Erfindung betrifft eine Vorrichtung zur leistungsarmen Stromerfassung mittels eines eine Shuntspannung erzeugenden Shuntwiderstandes.

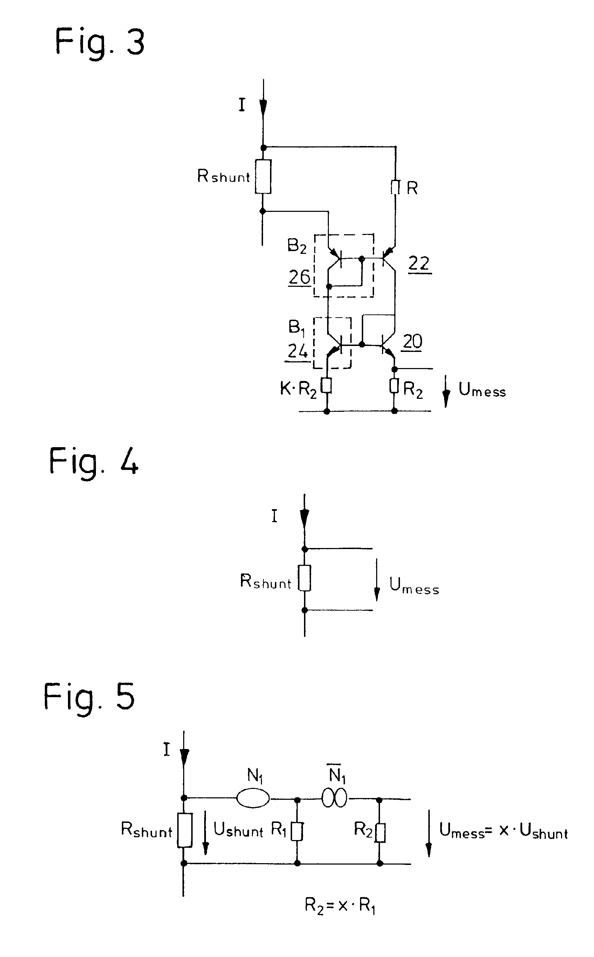

Eine derartige Strommessung zum Erzeugen einer Messspannung $U_{mess}$ über einem Shuntwiderstand $R_{shunt}$, wie schematisch in Fig. 4 gezeigt, ist aus dem Stand der Technik als prinzipieller Weg zur Strommessung bekannt.

Insbesondere in der Leistungselektronik, etwa bei Spannungswandlern, weisen gängige integrierte Schaltungen zur Ansteuerung entsprechender Leistungshalbleiter einen Eingang zur Regelung eines üblicherweise induktiven Stromes auf, wobei der erforderliche Spannungspegel, im Bereich von etwa 1 Volt, vergleichsweise hoch ist, um für einen günstigen Rausch-Spannungs-Abstand zu sorgen. Eine Stromerfassung erfordert hier (je nach Leistung) relativ große Widerstandswerte für einen Shuntwiderstand, mit damit verbundenen relativ hohen Verlusten und negativen Auswirkungen auf den Wirkungsgrad.

Eine aus dem Stand der Technik bekannte, mögliche Vorgehensweise zur Senkung der Verlustleistung wäre mittels eines Stromwandlers, etwa eines Transformators. Für eine dauernde Stromerfassung eignet sich jedoch ein Transformator aufgrund seiner magnetischen Eigenschaften (bzw. der Notwendigkeit eines solchen Stromwandlers, sich periodisch selbst zu entmagnetisieren) nicht.

Entsprechend könnte es sich daher anbieten, einen (zur Verminderung der Verlustleistung) kleinen Shuntwiderstand zu wählen und das entsprechend kleine Messsignal $U_{mess}$ durch einen geeigneten Verstärker zu verstärken, um dann eine geeignete Stromerfassung mittels einer nachgeschalteten Schaltungseinheit durchführen zu können.

Gängige, halbleiterbasierte Verstärkertopologien weisen allerdings den Nachteil auf, dass diese, insbesondere wenn sie mehrstufig realisiert sind, aufwendig im Aufbau sind, oftmals über den Verstärkungsbereich eine nicht lineare Verstärkungscharakteristik aufweisen und zudem nur in einem begrenzten Frequenzbereich betreibbar sind, d.h. in ihrer nutzbaren Frequenzbandbreite limitiert sind.

Insbesondere das Problem der Nichtlinearität eines gattungsbildenden, üblichen einstufigen Transistorverstärkers soll anhand des Prinzipschaltbildes der Figur 5 erläutert werden, wobei ein dem Shuntwiderstand $R_{shunt}$ nachgeschalteter Verstärkertransistor mit Hilfe der aus der Netzwerktheorie bekannten Zweipole "Nullator" N1 sowie "Norator"/N1, wie in der Fig. 5 mit Widerständen $R_1$, $R_2$ beschaltet, beschrieben werden soll. Genauer gesagt läßt sich ein Transistor als Nullator-Norator-Ersatzschaltbild derart beschreiben, dass der Basis-Emitterübergang durch den Nullator, und der Kollektor-Emitterübergang durch den Norator beschrieben werden; Nullator und Norator sind entsprechend am Emitter verbunden, so dass idealisiert die BasisEmitterspannung gleich Null sowie der Basisstrom gleich Null sind, und die Kollektor-Emitterspannung sowie der Kollektorstrom von der äußeren Beschaltung abhängig sind. Im Verstärker-Ersatzschaltbild der Fig. 5 entspricht dabei der Widerstand $R_1$ dem Emitterwiderstand, und $R_2$ dem Kollektorwiderstand, wobei sich der Verstärkungsfaktor -x für die Messspannung $U_{mess}$ als Quotient von $R_2$ und $R_1$ bildet. Bei dem in Fig. 5 gezeigten, prinzipiellen Ersatzschaltbild aus dem Stand der Technik ist dabei die Verstärkung negativ (d.h. mit Umkehrung der Polarität), so dass typischerweise der Anordnung nach Fig. 5 eine weitere Transistorstufe (als prinzipiell dieselbe Nullator-Norator-Kombination) mit einer angenommenen Verstärkung -y nachgeschaltet ist und die Gesamtverstärkung x • y damit positiv wird.

Bei der Anordnung der Fig. 5 handelt es sich, wie gesagt, um einen ansonsten bekannten einstufigen Transistorverstärker, wobei die verwendete Form der Beschreibung mit den aus der Netzwerktheorie bekannten, idealisierten Netzwerkelementen Norator und Nullator noch auf ein prinzipbedingtes Problem hinweist, nämlich eine tatsächliche Nichtlinearität des Nullators $N_1$, wenn dieser mit konkreten Bauelementen, z. B. einem Transistor, realisiert ist, mit einer entsprechend nachteiligen Wirkung auf die Genauigkeit der Messanordnung über den Gesamtbereich. Diese tatsächliche Nichtlinearität ist das Ergebnis einer Beeinflussung (Modulation) des Nullators durch den zugehörigen Norator/$N_1$ und führt zu der nichtlinearen Verstärkungscharakteristik des Systems und mithin dessen schlechter Eignung für eine hochpräzise Stromerfassung.

Aufgabe der vorliegenden Erfindung ist es daher, bei gattungsbildenden Messanordnungen zur leistungsarmen Stromerfassung mittels Shuntwiderstand die Linearität eines nachgeschalteten Verstärkernetzwerkes zu verbessern, wobei die Verlustleistung über dem Shuntwiderstand (und mithin die durch die Strommessung bewirkte Verschlechterung des Wirkungsgrades) minimiert bleiben soll.

Die Aufgabe wird durch die Vorrichtung mit den Merkmalen des Patentanspruches 1 gelöst, wobei, wie im Patentanspruch 9 beansprucht, sich die vorliegende Erfindung insbesondere zur Verwendung mit Spannungswandlern in der Leistungselektronik, und dort weiter bevorzugt für DC-DC-Wandler, eignet. Vorteilhafte Weiterbildungen der Erfindung sind in den Unteransprüchen beschrieben.

So ist erfindungsgemäß und vorteilhaft vorgesehen, der ersten Nullator-Norator-Kombination eine zweite Nullator-Norator-Kombination, bevorzugt jeweils als Transistor bzw. Transistorpaar realisiert, so vorzuschalten, dass durch die zweite Nullator-Norator-Kombination eine Kompensation eines nichtlinearen Verstärkungsverhaltens der ersten Nullator-Norator-Kombination erfolgen kann. Erreicht wird dies durch eine Rückkopplung, wobei das Rückkoppelsignal für die zweite Nullator-Norator-Kombination am Ausgang der ersten Kombination erzeugt wird.

In praktisch besonders bedeutsamer Weise werden die jeweiligen Nullator-Norator-Kombinationen als Transistoren bzw. Transistorpaare implementiert, wobei der Strom durch die zweite Nullator-Norator-Kombination (als Transistor) mit Hilfe eines weiteren Nullators (desselben Transistorpaares) so eingestellt wird, dass in der Reihenschaltung aus erstem Nullator (der ersten Kombination) und zweitem Nullator (aus der zweiten Kombination) der gewünschte Linearisierungseffekt entsteht.

Der Grad der Rückkopplung (wichtig ist, dass ein Schwingen bzw. Aufschwingen der Anordnung unterdrückt wird) wird dabei durch die jeweiligen Emitterwiderstände eingestellt. Während hierfür einerseits Wi-derstandsbauelemente bzw. diskrete Widerstände ver-wendet werden können, bietet es sich auch im Rahmen der vorliegenden Erfindung an, derartige Widerstandswerte durch entsprechende Dimensionierung der verwendeten Halbleiter selbst einzustellen; dieser Ansatz ist insbesondere für eine Realisierung der vorliegenden, erfindungsgemäßen Verstärkertopologie als integrierte Schaltung geeignet.

Im Ergebnis läßt sich so eine äußerst (verlust-) leistungsarme Stromerfassung realisieren, da, zum Erzeugen einer Shuntspannung im Millivolt-Bereich, lediglich ein Shuntwiderstand im Milliohm-Bereich notwendig ist. Gleichzeitig ermöglicht es das vorliegende Erfindungsprinzip, eine sehr hohe maximale Grenzfrequenz zu realisieren, so dass die erfindungsgemäße Stromerfassung nicht nur über den Verstärkungsbereich hochgradig linear ist, sondern zudem eine hohe nutzbare Bandbreite der Betriebsfrequenz aufweist.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in

Fig. 1: ein erstes, schematisches Schaltbild einer er-findungsgemäßen Vorrichtung zur leistungs-armen Stromerfassung gemäß einer ersten, bevorzugten Ausführungsform der Erfindung;

Fig. 2: eine konkrete schaltungstechnische Realisierung der Ausführungsform gemäß Fig. 1;

Fig. 3: eine zweite, alternative Ausführungsform der vorliegenden Erfindung;

Fig. 4: ein generelles Prinzip zur Strommessung mittels Shuntwiderstand aus dem Stand der Technik und

Fig. 5: ein Prinzipschaltbild einer Strommessung mittels Shuntwiderstand sowie nachgeschal-tetem, einstufigem Transistorverstärker, wel-cher als Nullator-Norator-Kombination dargestellt ist.

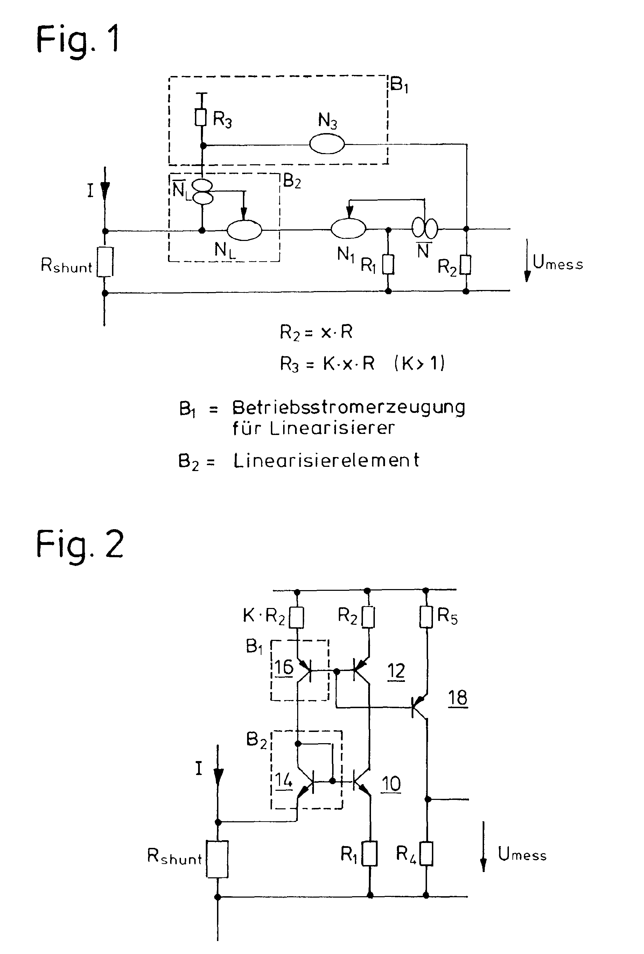

Unter Bezug auf Fig. 1 wird deutlich, dass eine erste Kombination aus Nullator $N_1$ und Norator/$N_1$ mit zugehörigen Widerständen $R_1$ bzw. $R_2$, entsprechend dem Transistorverstärker aus dem Stand der Technik gemäß Fig. 5, eine zweite Nullator-Norator-Kombinati-on (gestrichelte Linie $B_2$) in Richtung auf den Shuntwi-derstand $R_{shunt}$ vorgeschaltet aufweist. Genauer gesagt liegt ein zweiter Nullator $N_L$ der zweiten Nullator-Nora-tor-Kombination $B_2$ in Reihe mit dem ersten Nullator $N_1$, während der zugeordnete zweite Norator/$N_L$ über einen Widerstand $R_3$ mit Masse verbunden ist. In der Fig. 1 symbolisieren die jeweils vom Norator auf den Nullator weisenden Pfeile die einem tatsächlichen, nichtlinearen Verhalten entsprechenden Rückwirkungen (Modulationen) des betreffenden Norators auf den zugehörigen Nullator.

Zusätzlich ist in Fig. 1, symbolisiert mit der ge-strichelten Linie $B_1$, ein weiterer Nullator $N_3$ gezeigt, welcher den Ausgang des ersten Norators/$N_1$ (und mit-hin den Ausgang für die Messspannung $U_{mess}$) auf den Eingang des zweiten Norators/$N_L$ rückkoppelt, wobei mittels Widerstand $R_3$ der Betriebsstrom für die zweite (kompensierende) Nullator-Norator-Kombination $B_2$ so eingestellt wird, dass er dem Betriebsstrom der ersten Nullator/Norator-Kombination entspricht und der Kopp-lungsfaktor durch den Widerstandswert $R_3$ bestimmt wird.

Genauer gesagt bestimmt sich die Verstärkung der in Fig. 1 symbolisch gezeigten Anordnung wiederum durch den Faktor x als Quotient von $R_2$ und $R_1$, und auch ein Verstärkungsfaktor bzw. Kopplungsfaktor k der zweiten Nullator-Norator-Kombination $B_2$ be-stimmt sich analog als Quotient aus $R_3$ und $R_2$, so dass gelten muss:

$$R_3 = k \cdot R_2 = k \cdot x \cdot R_1$$

(wobei vorteilhaft k > 1 gelten sollte, damit die Anordnung robust läuft und nicht schwingen kann).

Die Fig. 2 verdeutlicht eine konkrete schal-tungstechnische Umsetzung des symbolischen Netz-werkschaltbildes gemäß Fig. 1, wobei die erste Nulla-tor-Norator-Kombination $N_1$, /$N_1$ durch ein npn/pnp-Transistorpaar 10, 12 realisiert ist, die zweite Nulla-tor-Norator-Kombination $B_2$ durch einen npn-Transistor 14 realisiert ist, und der dritte Nullator $N_3$ als weiterer pnp-Transistor 16 realisiert ist. Entsprechend findet eine Einstellung der Rückkopplung durch geeignete Bemessung des Faktors k für den Emitterwiderstand $R_3 = k \cdot R_2$ für den Transistor 16, relativ zum Emitterwiderstand $R_2$ für den Transistor 12 statt, und der Verstärkungsfaktor für die Schaltanordnung am Kollektorausgang der Transistoren 12 bzw. 14 bestimmt sich entsprechend durch den Quotienten aus Emitterwiderstand $R_2$ und Emitterwiderstand $R_1$ für den Transistor 10.

Wie sich aus der Fig. 2 zudem ergibt, ist der Anordnung aus den Transistoren 10 bis 16 (die in der gezeigten Verschaltung einen doppelten Stromspiegel ausbilden) eine weitere Verstärkerstufe mittels Transistor 18 nachgeschaltet, an welchem kollektorseitig dann die eigentliche Messspannung $U_{mess}$ abgegriffen wird, wobei dieser weitere Transistor 18 in ansonsten bekannter Weise durch Widerstände $R_4$ bzw. $R_5$ beschaltet ist. Wie vorstehend bereits erläutert, dient die zusätzliche Verstärkerstufe mit Transistor 18 jedoch lediglich dazu, eine negative Polarität des verstärkten Spannungssignals am Kollektor der Transistoren 10 bzw. 12 wiederum umzukehren.

Im Betrieb wird durch den als Betriebsstromerzeuger für den Transistor 14 mit dem Widerstand k • $R_2$ beschalteten Transistor 16 eine Rückkopplung erreicht, die, durch entgegengesetzt geschaltete Charakteristik, mit der eigenen nichtlinearen Verstärkung eine Nichtlinearität des Transistors 10 kompensiert, so dass im Ergebnis eine Verstärkeranordnung entsteht, die über einen weiten Verstärkungsbereich weitgehend lineare Verstärkungseigenschaften aufweist und somit für genaue Strommessungen geeignet ist. Gleichzeitig zeichnet sich diese Anordnung durch einen vergleichsweise einfachen Schaltungsaufbau aus (eignet sich damit insbesondere auch für eine Integration in einem integrierten Schaltkreis) und weist eine hohe maximale Grenzfrequenz auf, die sich insbesondere auch für den Einsatz im Zusammenhang mit Spannungswandlern in der Leistungselektronik geeignet macht.

In der praktischen Realisierung entsteht so eine Anordnung, die bei einem typischen Shuntwiderstand von etwa 1 bis 500 mOhm, bevorzugt 10 bis 200 Milliohm und einer Shuntspannung im Millivoltbereich, typischerweise 10 bis 50 Millivolt, einen Verstärkungsfaktor der Größenordnung von 10 realisiert. Die Verstärkerschaltung ist bis zum dreistelligen MHz-Bereich brauchbar.

Fig. 3 zeigt eine alternative Realisierungsform des Ausführungsbeispiels gemäß Fig. 2, dergestalt, dass Transistoren 20 bis 26 eine entsprechende (doppelte) Stromspiegelschaltung realisieren, jedoch jeweils mit umgekehrter Polarität der verwendeten Transistoren, so dass eine nachgeschaltete Verstärkerstufe (mittels Transistor 18 in Fig. 2) zur Polaritätsumkehr entfallen kann.

Die vorliegende Erfindung ist nicht auf die gezeigten Ausführungsbeispiele beschränkt. So bietet es sich insbesondere an, die gezeigten Ausführungsbeispiele, anstelle mit diskreten Transistorbauelementen zu realisieren, auch durch entsprechende integrierte Schaltungsumgebungen zu realisieren, wobei es hier besonders bevorzugt ist, die jeweils zugeordneten Widerstände durch geeignete Bemessung der Halbleiterelemente selbst bzw. der entsprechenden dotierten Flächen und Bahnen umzusetzen. Alternativ ist es möglich und von der vorliegenden Erfindung mitumfasst, die zur prinzipiellen Erläuterung der vorliegenden Erfindung verwendeten Netzwerk-Zweipole Norator und Nullator in der gezeigten Weise durch andere Halbleiterbauelemente, etwa Operationsverstärker od.dgl., zu implementieren.

**Patentansprüche**

1.  Vorrichtung zur leistungsarmen Stromerfassung mittels eines eine Shuntspannung erzeugenden Shuntwiderstands ($R_{shunt}$), mit
    einem zum Verstärken der Shuntspannung in eine Messspannung ausgebildeten Verstärkernetzwerk, das eine erste, als Verstärker beschaltete Nullator-Norator-Kombination ($N_1$, /$N_1$) aufweist,
    **dadurch gekennzeichnet, dass**
    der ersten Nullator-Norator-Kombination eine zweite Nullator-Norator-Kombination ($B_2$) in Richtung auf den Shuntwiderstand so in Reihe vorgeschaltet ist, dass der erste Nullator und der zweite Nullator in einer Rückkopplung betrieben werden und eine Nichtlinearität des ersten Nullators durch ein entgegengesetztes Verhalten des zweiten Nullators kompensiert werden kann,
    wobei ein Rückkoppelsignal für die zweite Nullator-Norator-Kombination am Ausgang der ersten Nullator-Norator-Kombination abgegriffen wird.

2.  Vorrichtung nach Anspruch 1, **dadurch gekennzeichnet, dass** die erste Nullator-Norator-Kombination als kollektorseitig verbundenes npn/pnp-Transistorpaar (10, 12; 20, 22) realisiert ist und die zweite Nullator-Norator-Kombination ein Transistor (14; 24) eines zweiten npn/pnp-Transistorpaares (14, 16; 24, 26) ist, dessen Betriebsstrom so eingestellt ist, dass er eine Nichtlinearität eines als Nullator wirkenden Transistors des ersten Transistorpaares kompensiert.

3.  Vorrichtung nach Anspruch 2, **dadurch gekennzeichnet, dass** eine Betriebsstromerzeugung ($B_1$) für die zweite Nullator-Norator-Kombination durch einen zweiten Transistor (16; 26) des zweiten npn/pnp-Transistorpaares realisiert ist.

4.  Vorrichtung nach Anspruch 2 oder 3, **dadurch gekennzeichnet, dass** eine Verstärkung des Verstärkernetzwerkes durch emitterseitig vorgesehene Widerstände ($R_1$, $R_2$, k • $R_2$) an den Transistorpaaren eingestellt ist.

5.  Vorrichtung nach einem der Ansprüche 2 bis 4, **dadurch gekennzeichnet, dass** ein Grad der Rückkopplung (k) durch ein Widerstandsverhältnis eines Emitterwiderstands ($R_3$) der zweiten Nullator-Norator-Kombination relativ zu einem entsprechenden Emitterwiderstand ($R_2$) der ersten Nullator-Norator-Kombination, oder durch Dimensionierung der Halbleitergeometrien von die erste bzw. die zweite Nullator-Norator-Kombination realisierenden Halbleitern, eingestellt ist.

6.  Vorrichtung nach einem der Ansprüche 1 bis 5, **dadurch gekennzeichnet, dass** ein Verstärkungsfaktor des Verstärkernetzwerkes zwischen 5 und 20 liegt.

7.  Vorrichtung nach einem der Ansprüche 1 bis 6, **dadurch gekennzeichnet, dass** der Shuntwiderstand einen Wert im Bereich zwischen 1 und 500 mOhm aufweist.

8.  Vorrichtung nach einem der Ansprüche 1 bis 7, **dadurch gekennzeichnet, dass** eine maximale Betriebsfrequenz des Verstärkernetzwerkes im Bereich zwischen 10 und 100 MHz liegt.

9.  Verwendung der Vorrichtung nach einem der Ansprüche 1 bis 8 zur Stromerfassung in einem DC-DC-Wandler.

# Fig. 1

$$R_2 = x \cdot R$$

$$R_3 = K \cdot x \cdot R \quad (K > 1)$$

$B_1$ = Betriebsstromerzeugung
für Linearisierer

$B_2$ = Linearisierelement

# Fig. 2

## Fig. 3

## Fig. 4

## Fig. 5